(19) Europäisches Patentamt / European Patent Office / Office européen des brevets

(11) **EP 2 319 177 B1**

(12) **FASCICULE DE BREVET EUROPEEN**

(45) Date de publication et mention
de la délivrance du brevet:
**26.06.2019 Bulletin 2019/26**

(21) Numéro de dépôt: **09782092.2**

(22) Date de dépôt: **21.08.2009**

(51) Int Cl.:
***H03H 17/02*** *(2006.01)*

(86) Numéro de dépôt international:
**PCT/EP2009/060845**

(87) Numéro de publication internationale:
**WO 2010/026064 (11.03.2010 Gazette 2010/10)**

(54) **DISPOSITIF DE FILTRAGE A STUCTURE HIERARCHIQUE ET DISPOSITIF DE FILTRAGE RECONFIGURABLE**

FILTERANORDNUNG MIT HIERARCHISCHER STRUKTUR UND UMKONFIGURIERBARE FILTERANORDNUNG

FILTERING DEVICE WITH A HIERARCHICAL STRUCTURE, AND RECONFIGURABLE FILTERING DEVICE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **05.09.2008 FR 0804884**

(43) Date de publication de la demande:
**11.05.2011 Bulletin 2011/19**

(73) Titulaire: **Commissariat à l'Énergie Atomique et aux Énergies Alternatives 75015 Paris (FR)**

(72) Inventeurs:
- **PAJANIRADJA, Suresh**
  **F-92340 Bourg La Reine (FR)**
- **GUIBERT, Mickael**
  **F-94170 Le Perreux-sur-marne (FR)**
- **SCHMIT, Renaud**
  **F-28700 Anneau (FR)**

(74) Mandataire: **Brunelli, Gérald et al Marks & Clerk France Immeuble Visium 22, avenue Aristide Briand 94117 Arcueil Cedex (FR)**

(56) Documents cités:
**EP-A- 0 623 996     EP-A- 1 176 717
US-A- 5 487 023     US-A1- 2005 283 508**

- **TORRES L ET AL: "A reconfigurable digital filter chip for image processing" ASIC/SOC CONFERENCE, 1999. PROCEEDINGS. TWELFTH ANNUAL IEEE INTERNATIO NAL WASHINGTON, DC, USA 15-18 SEPT. 1999, PISCATAWAY, NJ, USA,IEEE, US, 15 septembre 1999 (1999-09-15), pages 93-97, XP010360316 ISBN: 978-0-7803-5632-0**

**EP 2 319 177 B1**

**Description**

L'invention concerne un dispositif de filtrage numérique à structure hiérarchique reconfigurable et s'applique notamment aux domaines du traitement du signal, du traitement d'image, du filtrage et des télécommunications.

Les filtres linéaires sont très utilisés en traitement d'image, en traitement du signal et dans les télécommunications.

En traitement d'image ils permettent de réduire le bruit, d'augmenter le contraste, de lisser, d'extraire des caractéristiques grossières ou bien d'extraire les contours d'une image. A titre d'exemple, les opérateurs de Sobel et de Prewitt permettent de détecter les contours d'une image. Une convolution matricielle de l'image est effectuée en utilisant un masque de convolution à deux dimensions, le masque étant de taille 3x3. Cette convolution est conduite dans le domaine spatial discret et s'implémente dans la pratique grâce à un filtre à réponse impulsionnelle finie FIR d'ordre 3.

D'autres méthodes plus précises de détection de contour utilisent des filtres à réponse impulsionnelle infinie IIR. Les filtres IIR sont plus complexes à mettre en oeuvre que les filtres FIR à cause de leur caractéristique récursive. En effet, la sortie du filtre dépend des échantillons d'entrée mais également des résultats précédents résultants du filtrage. Par ailleurs, le type d'alimentation de données doit être différent afin de présenter un flux anti-causal en entrée du filtre. A titre d'exemple, les filtres de Deriche et de Shen, très utilisés en traitement d'images, sont des filtres IIR respectivement d'ordre 2 et d'ordre 1. Le filtre de Deriche permet d'effectuer une détection de contours sur une image traitée se basant sur des calculs de gradients. Le gradient selon l'axe des abscisses est calculé en utilisant un filtre de lissage suivant la direction des ordonnées, puis un filtre dérivateur suivant la direction des abscisses. Chacun des deux filtres se décompose en une partie causale et une partie anti-causale. Un autre filtre de lissage et un autre filtre dérivateur sont par ailleurs nécessaires pour calculer le gradient selon l'axe des ordonnées. Quatre filtres récursifs sont donc nécessaires pour réaliser la détection de contour avec cette méthode.

Il est de plus en plus courant qu'un système de traitement du signal ait la capacité de réaliser plusieurs applications concurrentes. Dans le cas d'un système de traitement d'image, les algorithmes font typiquement appel à plusieurs types d'opérations à réaliser sur les images, notamment des opérations de filtrage linéaire. Plusieurs types de filtres peuvent être calculés et combinés pour extraire l'information utile de l'image. Un module matériel ayant une forte puissance de calcul tout en permettant une certaine flexibilité pour exécuter des fonctions différentes est aujourd'hui particulièrement utile dans un système embarqué.

Les solutions existantes permettant de réaliser des opérations de filtrage linéaire sont réalisées typiquement à l'aide de processeurs ou d'architectures dédiées.

Dans le cas des solutions à base de processeurs embarqués, il est possible de réaliser des opérations de filtrage linéaire avec des processeurs généralistes, avec des processeurs de traitement du signal dits DSP, ou bien avec des processeurs spécifiques du type SIMD. De par leur possibilité de programmation, l'utilisation de processeurs permet une implémentation flexible, mais la puissance de calcul disponible reste limitée. En effet, afin de réaliser un filtrage de longueur N, un processeur généraliste classique nécessite typiquement 4xN cycles d'horloge par pixel d'image pour effectuer une convolution.

Un processeur DSP est plus adapté à ce genre d'opération mais requière N/2 cycles par pixel d'image.

De par sa structure fortement parallèle, un processeur SIMD est particulièrement adapté à la convolution linéaire mais l'est moins pour la réalisation de filtres récursifs. Cela est dû à la gestion de différents types d'accès aux données (causal et anti-causal) ainsi qu'à la dépendance aux résultats précédents propre aux filtres récursifs. De plus, ce type de calcul demande une précision importante et une grande dynamique de calcul. Les processeurs SIMD embarqués sont limités concernant ces deux aspects.

Une implémentation basée sur une architecture dédiée permet d'optimiser les temps de traitement mais n'est pas suffisamment flexible. Il est difficile dans ce cas d'implémenter sur une même architecture à la fois des filtres FIR et des filtres IIR tout en optimisant le coût en Silicium.

Il apparaît que les solutions existantes permettent soit une grande flexibilité de mise en oeuvre au prix de faibles performances de calculs, soit à l'inverse de bonnes performances de calculs au prix d'une flexibilité d'utilisation limitée. EP 0 623 996 A divulgue un filtre reconfigurable.

Un but de l'invention est notamment de palier les inconvénients précités. A cet effet l'invention a pour objet un dispositif de filtrage à structure hiérarchique configurable pour permettre de réaliser soit des fonctions de filtrage linéaire à réponse impulsionnelle finie soit à réponse impulsionnelle infinie et pouvant être combiné avec un ou plusieurs dispositifs du même type, ledit dispositif comportant au moins un premier (1) et un second (2) module de filtrage comportant des moyens pour réaliser des fonctions de filtrage à N coefficients configurables,

un premier sous ensemble des N coefficients d'un module de filtrage étant configuré de manière à réaliser des fonctions de filtrage non-récursif, un second sous ensemble desdits coefficients pouvant être configuré de manière à réaliser des fonctions de filtrage récursif, une ou plusieurs boucles de contre-réaction pouvant être activée par module de filtrage, le dispositif étant configuré de manière à ce que les échantillons de sortie du premier module de filtrage sont dirigés soit directement en entrée du second module de filtrage soit vers un port de sortie du dispositif de filtrage, au moins un échantillon de résultat du filtrage étant généré à chaque cycle d'horloge, le dispositif de filtrage comportant au moins :

un port d'entrée principal (4) transmettant au dispositif de filtrage un flux d'échantillons à filtrer, ledit port étant connecté aux deux modules de filtrage (1, 2) ;
un port d'entrée secondaire (3) connecté au premier module de filtrage (1) permettant de transmettre un second flux d'échantillons au dispositif de filtrage ;
un port de sortie principal (11) permettant de transmettre le résultat des opérations de filtrage en sortie du dispositif de filtrage après combinaison (10) des flux en sortie de chaque module de filtrage reconfigurable ;
un port de sortie secondaire (12) permettant de transmettre un résultat après filtrage composé d'un flux d'échantillons pris en sortie du second module de filtrage (2), ledit port pouvant être connecté au port d'entrée secondaire (3) d'un autre dispositif de filtrage numérique ; et
un premier circuit LIFO placé en sortie du premier module de filtrage (1) et un deuxième circuit LIFO placé en entrée du second module de filtrage (2) pour générer des flux d'échantillons anti-causaux, lesdits circuits LIFO n'étant pas activés lorsque les modules de filtrage sont configurés pour réaliser des filtres à réponse impulsionnelle finie et lesdits circuits LIFO étant activés lorsque les modules de filtrage sont configurés pour réaliser des filtres à réponse impulsionnelle infinie,
lesdits circuits LIFO, lorsqu'ils sont activés, réalisent simultanément un traitement récursif causal du flux d'échantillons à filtrer, l'ordre des échantillons en sortie du premier module de filtrage étant inversé par le premier circuit LIFO et un traitement récursif anti-causal du flux d'échantillons à filtrer dont l'ordre des échantillon est inversé par le deuxième circuit LIFO.

Le flux d'échantillons présenté au port d'entrée secondaire est, par exemple, un flux d'échantillons à traiter indépendant du flux présenté au port d'entrée principal.

Le flux d'échantillons est, par exemple, un flux en provenance d'un autre dispositif DFSH, les deux dispositifs étant connectés afin de réaliser une fonction de filtrage d'ordre supérieur à N.

Le dispositif de filtrage peut être paramétré de manière à réaliser au moins trois configurations de filtrage, la première configuration correspondant à un filtre IIR 2D d'ordre N/2, la seconde configuration correspondant à deux filtres FIR 2D d'ordre N et la troisième configuration correspondant à un filtre FIR 2D d'ordre $2 \times N$.

Les valeurs des coefficients de filtrage utilisés par chaque module de filtrage MF sont stockées, par exemple, dans des registres programmables.

Des flux d'échantillons anti-causaux sont générés, par exemple, par des circuits LIFO, lesdits circuits LIFO étant placés en sortie du premier module de filtrage MF et en entrée du second module de filtrage MF.

Les données traitées par ledit dispositif DFSH peuvent être, par exemples, au format entier, au format virgule fixe. Le dispositif de filtrage peut comporter un module de synchronisation permettant de compenser automatiquement les différences de latence entre les sorties des deux modules de filtrage.

Par exemple, chaque module de filtrage MF utilisé par le dispositif comporte au moins N multiplieurs, N cellules à retard, deux arbres d'additionneurs, un port d'entrée principale, un port d'entrée secondaire, un port de sortie principale et un port de sortie secondaire.

Chaque module de filtrage utilisé par le dispositif comporte, par exemple, une fonction de réalignement en amont du port de sortie principale lorsque les échantillons à traiter sont représentés au format virgule fixe et une fonction de compensation placé en amont du port de sortie secondaire permettant d'équilibrer les latences introduites par les multiplieurs et les arbres d'additionneurs.

Le routage des flux de données en interne du dispositif est choisi, par exemple, à l'aide à de bascules d'aiguillage.

L'invention a aussi pour objet un dispositif de filtrage reconfigurable DFR utilisant au moins deux dispositifs de filtrage à structure hiérarchique DFSH, ledit dispositif comportant au moins quatre ports d'entrée permettant de présenter en entrée du dispositif un ou plusieurs flux d'échantillons à filtrer, quatre ports de sortie permettant de présenter en sortie du dispositif le ou les flux résultant de la ou des opérations de filtrage réalisées par le dispositif, un circuit d'aiguillage reconfigurable permettant d'une part de router les flux d'entrée soit vers les ports d'entrée principaux soit vers les ports d'entrée secondaires de l'un ou l'autre des dispositifs DFSH, et d'autre part de router les résultats disponibles sur les ports de sortie principaux ou secondaires des dispositifs DFSH soit en sortie du dispositif DFR soit vers les ports d'entrée principaux au secondaires d'un autre dispositifs DFSH.

L'invention a notamment comme avantage de proposer une solution permettant de mettre en oeuvre plusieurs types de filtres sur une même architecture, soit d'une part des filtres à réponse impulsionnelle finie FIR et d'autre part des filtres à réponse impulsionnelle infinie RII. L'ordre et la taille des filtres est paramétrable et permet d'utiliser la même architecture dans le cadre d'applications concurrentes. Un autre avantage de l'invention est que l'architecture proposée permet une exécution efficace et rapide des fonctions de filtrage même lorsque la taille des filtres est importante. Il est donc possible de traiter, par exemple, des images de résolution importante. L'invention est utilisable dans le cadre de la mise en oeuvre de plusieurs types d'algorithmes de traitement de signal tout en optimisant le coût d'implémentation et en réduisant l'occupation en silicium des systèmes utilisant l'invention.

D'autres caractéristiques et avantages de l'invention apparaitront à l'aide de la description qui suit donnée à titre illustratif et non limitatif, faite en regard des dessins annexés parmi lesquels :

- la figure 1 illustre un exemple de dispositif de filtrage à structure hiérarchique selon l'invention, ledit dispositif étant désigné par l'acronyme DFSH ;
- la figure 2 présente un exemple de module de filtrage reconfigurable à N coefficients utilisé par le dispositif de filtrage à structure hiérarchique DFSH, ledit module étant désigné par l'acronyme MF ;
- la figure 3 illustre un exemple de dispositif de filtrage reconfigurable utilisant plusieurs dispositifs DFSH, ledit dispositif étant désigné par l'acronyme DFR.

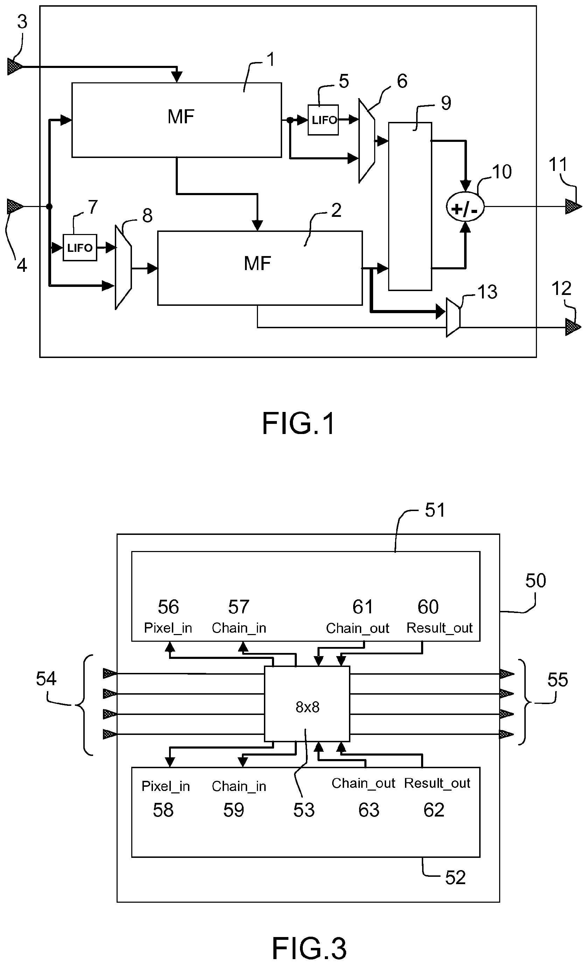

La figure 1 présente un exemple de dispositif de filtrage à structure hiérarchique reconfigurable DFSH selon l'invention. Sur cet exemple, le dispositif est composé de deux modules de filtrage reconfigurables MF à N coefficients 1, 2 représentant le coeur de calcul du dispositif. Chacun de ces modules est composé d'un circuit matériel permettant de réaliser des fonctions de filtrage linéaire à N coefficients. Ces modules MF peuvent être configurés de manière à réaliser des filtres à réponse impulsionnelle finie FIR ou des filtres à réponse impulsionnelle infinie IIR et produisent un échantillon de résultat à chaque cycle d'horloge. Un module MF comportant N coefficients est capable de réaliser les N multiplications et N-1 additions d'un filtre, récursif ou non, en 1 seul cycle d'horloge. Les flux d'échantillons arrivent à la cadence d'un échantillon par cycle d'horloge et le module MF produit un échantillon résultat par cycle d'horloge. Ainsi, le circuit permet d'effectuer des calculs de filtrage de façon parallèle et aussi rapidement que la fréquence d'horloge le permet. La même fonction peut être réalisée sur des processeurs programmables de type CPU mais lesdits processeurs CPU ne peuvent pas produire un échantillon résultat tous les cycles d'horloge.

Le dispositif DFSH comprend par ailleurs deux ports d'entrée, soit un port d'entrée principal 4 et un port d'entrée secondaire 3.

Le port d'entrée principal 4 permet de recevoir le flux des échantillons d'entrée à filtrer, le flux pouvant être composé, par exemple, des pixels d'une image.

Le port d'entrée secondaire 3 peut être utilisé de deux manières. Dans une première utilisation, le port d'entrée secondaire 3 est utilisé pour recevoir un second flux d'échantillons à traiter en parallèle du premier, par exemple un flux de pixels correspondant à une seconde image à traiter. Dans une deuxième utilisation, le port d'entrée secondaire est utilisé pour recevoir des résultats partiels de filtrage lorsque plusieurs dispositifs DFSH sont utilisés en série.

En outre, le dispositif DFSH comprend deux ports de sortie, soit un port de sortie principal 11 et un port de sortie secondaire 12.

Le port de sortie principal 11 transmet en sortie du dispositif les échantillons résultats des opérations de filtrage.

Le port de sortie secondaire 12 peut être utilisé de deux manières. Dans une première configuration, le port de sortie secondaire 12 est utilisé pour transmettre les résultats du deuxième module MF 2 en sortie du dispositif. Ce port secondaire 12 peut être utilisé comme une seconde sortie de filtrage lorsque le dispositif est configuré pour réaliser plusieurs filtres en parallèle. Dans une deuxième configuration, le port de sortie secondaire 12 transmet en sortie du dispositif les échantillons présentés au port d'entrée principal 4. Cette configuration est choisie notamment lorsque le dispositif DFSH est combiné avec un ou plusieurs dispositifs DFSH du même type.

Comme expliqué précédemment, le dispositif DFSH est constitué de deux modules MF 1, 2 réalisant les opérations de filtrage. Chaque module MF a la capacité de réaliser un filtrage de type FIR ou IIR en fonction de la manière dont il a été configuré. Lorsque les modules sont configurés pour réaliser des filtres IIR, des circuits LIFO 5, 7, acronyme venant de l'expression anglo-saxonne «Last In First Out », sont utilisés et permettent de créer des sources de données anti causales. Ainsi, un dispositif DFSH est capable de réaliser en 1 seule passe et simultanément un traitement récursif causal, c'est-à-dire un traitement dont les résultats dépendent des échantillons d'entrée et des sorties passées, mais aussi un traitement récursif anti-causal, c'est-à-dire un traitement dont les résultats dépendent des échantillons d'entrée et des sorties futures. Les circuits LIFO sont des composants de mémorisation permettant d'inverser l'ordre des échantillons. A titre d'exemple, en sortie des circuits LIFO 5, 7, un flux $e_0$, $e_1$, ...$e_n$ est présenté en sortie dans l'ordre $e_n$, $e_{n-1}$, ...$e_1$, $e_0$. Cette inversion est indispensable pour des traitements récursifs de type Deriche ou Shen, par exemples. Les circuits LIFO sont basés sur des éléments mémoires de capacité suffisance pour mémoriser tous les échantillons d'entrée $e_0$, $e_1$,..., $e_n$. A titre d'exemple, dans une application de type traitement d'image, au moins une ligne d'image peut être mémorisée.

Un module de synchronisation 9 permet de compenser automatiquement les différences de latence entre les sorties des deux modules MF 1, 2 avant que celles-ci soient traitées par un additionneur/soustracteur 10. Les échantillons résultant sont ensuite dirigés vers le port de sortie principal 11. Le dispositif DFSH est configurable dans le sens ou chaque module MF est lui-même configurable. Par ailleurs, le routage des flux de données en interne du dispositif DFSH est également configurable grâce à des composants d'aiguillages 6, 8, 13.

L'exemple donné de dispositif DFSH permet de réaliser différents schémas de filtrage en fonction de la configuration des interconnections du dispositif et des modules MF 1, 2.

Si le dispositif DFSH est utilisé dans le cadre d'applications de traitement d'image, le dispositif permet d'effectuer un filtrage 1D, c'est-à-dire un traitement d'image ligne par ligne. Un filtrage 2D peut également être réalisé en réinjectant les résultats précédents colonne par colonne en entrée du dispositif DFSH. En effet, lorsque le masque de convolution 2D est décomposable en deux masques de convolution 1D, l'opération de filtrage 2D est équivalente à deux opérations de filtrage 1 D.

Le dispositif DFSH peut être paramétré pour réaliser au moins trois configurations de filtrage en deux passes de filtrage.

Une première configuration permet de réaliser un filtre IIR 2D d'ordre N/2. Pour cela, celui-ci peut être configuré de la manière suivante :

- les deux modules MF 1, 2 sont configurés en mode récursifs avec leurs boucles de contre réaction activées ;
- les deux circuits LIFO 5, 7 sont activés ;
- le port d'entrée principal 4 est utilisé et passe par le premier module MF 1 pour réaliser un traitement récursif causal dont l'ordre des échantillons est inversé par le premier circuit LIFO 5 disposé en sortie du premier module MF ;
- le flux d'échantillons présenté au port d'entrée principal 4 est inversé par le second circuit LIFO 7 et passe par le second module MF 2 pour la réalisation d'un traitement anti-causal ;
- les traitements causaux et anti-causaux sont synchronisés par le module de synchronisation 9 et combinés par l'additionneur/soustracteur 10, puis les échantillons résultats sont dirigés vers le port de sortie principal 11 ;
- une deuxième passe de calcul est effectuée sur les échantillons résultats issus des modules MF avec des coefficients appropriés afin de réaliser la fonction IIR 2D d'ordre m.

Une seconde configuration permet de réaliser deux filtres FIR 2D d'ordre N, ce qui veut dire que deux sources distinctes peuvent être traitées simultanément par le dispositif. Dans le cadre d'une application de traitement d'image, deux images pourront donc être traitées en parallèle. Pour cela, le dispositif DFSH est configuré de la manière suivante :

- les deux modules MF 1, 2 sont configurés en mode non-récursifs sans boucle de contre réaction activée. Le premier module MF 1 est configuré pour réaliser un traitement sur les échantillons présentés sur son port d'entrée secondaire, et le second module MF 2 est configuré pour réaliser un traitement sur les échantillons présentés sur son port d'entrée principal ;
- les deux circuits LIFO 5, 7 ne sont pas activés ;
- les deux multiplexeurs 6, 8 sont configurés de manière à contourner les circuits LIFO ;
- un flux d'échantillons est présenté au niveau du port d'entrée secondaire 3 et passe par le premier module MF 1, ledit module réalisant le traitement correspondant au premier filtre FIR ;
- le module de synchronisation 9 est configuré pour ne laisser passer que le flux issu du premier module MF 1 par une de ses sorties, la seconde sortie étant à forcée à 0.
- l'additionneur 10 transmet le flux inchangé d'échantillons de sortie du premier module MF 1 vers le port de sortie principal 11 ;
- un flux d'échantillons d'entrée présenté au niveau du port d'entrée principal 4 et indépendant du flux présenté au niveau du port d'entrée secondaire 3 est transmis au second module MF 2 pour réaliser le deuxième filtre FIR 2D ;
- une deuxième passe sur les résultats précédents dans ces modules avec des coefficients appropriés réalise la fonction FIR 2D d'ordre N.

Une troisième configuration permet de réaliser un filtre FIR 2D d'ordre 2xN. Dans ce cas, une seule source peut être traitée en deux passes de filtrage, mais la longueur de filtrage est deux fois plus importante que dans la deuxième configuration. Deux filtres FIR 2D indépendant d'ordre N sont réalisés lorsque que le dispositif DFSH est configuré de la manière suivante :

- les deux modules MF 1, 2 sont configurées en cascade en mode non-récursifs sans activer une boucle de contre réaction ;
- le premier module MF 1 est configuré pour réaliser un traitement sur les échantillons présenté sur son port d'entrée principal ;
- le second module MF 2 est configuré pour réaliser un traitement sur les échantillons présentés à son port d'entrée secondaire ;
- la sortie secondaire de premier module MF 1 est activée et est reliée à l'entrée secondaire du second module MF 2 ;
- les circuits LIFO 5, 7 ne sont pas activés ;
- les multiplexeurs 6, 8 sont configurés de manière à ce que les échantillons contournent les circuits LIFO ;

- les échantillons de la source à filtrer sont présenté au port d'entrée principal 4, les échantillons passent ensuite par le premier module MF 1 puis par le second module MF 2 pour réaliser le traitement de filtrage FIR d'ordre 2N ;
- le flux d'échantillons résultats sort du second module MF 2, passe par le multiplexeur 13 puis est présenté au port de sortie secondaire 12 ;
- une deuxième passe des résultats précédents réinjectés dans le port 4 dans ces modules avec des coefficients appropriés de MF 1 et MF2 réalise la fonction FIR 2D d'ordre 2N.

En combinant l'utilisation de plusieurs dispositifs DFSH, il est possible de réaliser des filtres de longueur supérieure à $2 \times N$.

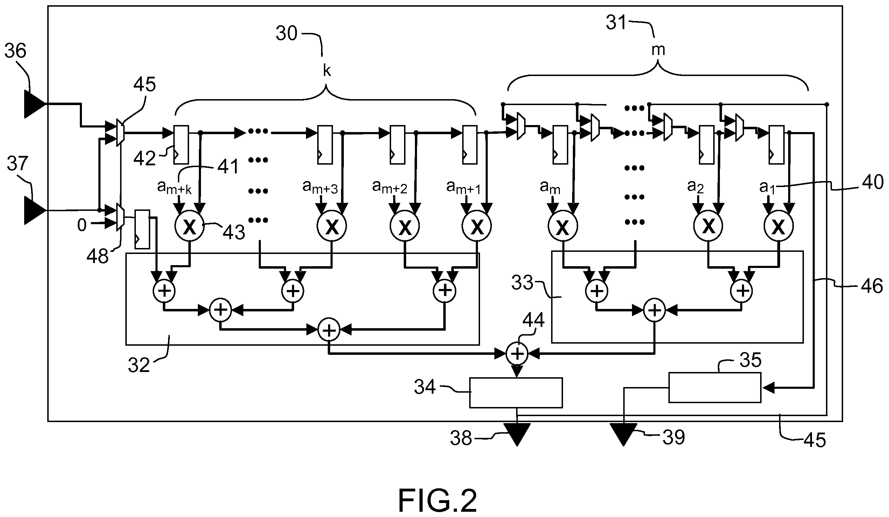

La figure 2 présente un exemple de module de filtrage reconfigurable MF pouvant être utilisé par le dispositif DFSH tel qu'illustré par la figure 1. Ce module permet de réaliser des fonctions de filtrage à N coefficients $a_1$ 40 à $a_N$ 41. Parmi ces N coefficients, k sont non-récursifs 30 et m sont récursifs 31 et N = m + k. Le module permet donc de réaliser des fonctions de filtrage FIR d'ordre N ou bien de filtrage IIR d'ordre m. Il est possible de configurer une boucle de retour de façon très précise en choisissant les valeurs des coefficients $a_1$ à $a_m$. Il est aussi possible d'activer plusieurs boucles de retour sur différents coefficients $a_1$ à $a_m$.

Un module MF comprend deux ports d'entrée, soit un port d'entrée principal 36 et un port d'entrée secondaire 37. Il comprend en outre deux ports de sortie, soit un port de sortie principal 38 et un port de sortie secondaire 39.

Les échantillons à filtrer sont présentés au port d'entrée principal 36 du module MF. A chaque cycle d'horloge, un échantillon résultat est disponible au niveau du port de sortie principal 38. Le module MF est composé de bancs de registres à décalage 42 et de N circuits multiplieurs 43 permettant de pondérer les échantillons retardés par les coefficients du filtre. Les valeurs desdits coefficients sont stockées dans des registres programmables.

Les résultats intermédiaires obtenus après application des retards et pondération des échantillons d'entrée sont additionnés en utilisant des arbres d'additionneurs 32, 33 respectivement pour la partie non récursive 30 et la partie récursive 31 du filtre. Le résultat de la sortie des deux arbres est ensuite additionné 44 et traité par une fonction de réalignement 34 dans le cas ou le module traite des données au format virgule fixe.

L'implémentation des multiplieurs 43 et additionneurs 32, 33 est réalisée, par exemple, avec des circuits combinatoires comportant des étages de « pipeline » pour augmenter la cadence de l'horloge.

Une boucle de retour 45 permet de réinjecter les résultats du filtrage en entrée de la partie récursive 31 du filtre. Cette voie de retour n'est utilisée que lorsque le module est configuré afin de réaliser un filtrage IIR. La boucle de contre réaction est reconfigurable, ce qui permet d'ajuster la profondeur de la partie récursive 31 du filtre. Comme expliqué précédemment, les valeurs des coefficients du filtre est programmable. Elles peuvent donc être choisies en fonction de l'application ciblée.

Il est également possible d'augmenter l'ordre du filtre à réaliser en utilisant deux modules MF connectés l'un à l'autre. S'il est possible de réaliser une fonction de filtrage FIR d'ordre N avec un module, il est également possible, par exemple, de réaliser une fonction de filtrage FIR d'ordre $2 \times N$ en utilisant deux modules MF. Le module comporte donc un couple entrée-sortie principal 36, 38 et un couple d'entrée-sortie secondaire 37, 39 utilisé lorsque plusieurs modules MF sont combinés, comme c'est le cas pour le dispositif DFSH de la figure 1. Les latences des multiplieurs et des arbres d'additionneurs sont équilibrées par une fonction de compensation 35 prenant en entrée la sortie 46 de la partie récursive 31 du filtre. Le résultat après compensation est présenté au port de sortie secondaire 39 du premier module MF pour être réinjecté au niveau du port d'entrée secondaire 37 du second module MF.

Dans le cas où le module MF est configuré afin de réaliser un filtre FIR, la fonction réalisée est la suivante :

$$F_{FIR}(e_i) = \sum_{j=1}^{N} a_j \times e_{i-j} \qquad (1)$$

où les échantillons d'entrée à filtrer sont notés $e_i$ et les coefficients du filtre FIR sont notés $a_j$.

Cette fonction permet en configurant les coefficients d'exécuter un filtre 1D. Si l'application cible nécessite la mise en oeuvre d'un filtre 2D, les coefficients seront réajustés et les résultats du premier filtrage seront réinjectés au niveau du port d'entrée principal 36 du module.

Dans le cas où le module est configuré afin de réaliser un filtre IIR, la fonction réalisée est la suivante :

$$F_{IIR}(e_i) = \sum_{j=1}^{k} a_{m+j} \times e_{i-j} + \sum_{j=1}^{m} a_{m-j+1} \times F_{IIR}(e_{i-j}) \qquad (2)$$

les échantillons d'entrée à filtrer étant notés $e_i$, les m premiers coefficients $a_i$ du filtre IIR correspondant à la partie récursive du filtre et les k suivants à pour la partie non récursive.

La figure 3 présente un exemple de dispositif de filtrage reconfigurable DFR 50. Deux dispositifs DFSH 51, 52 sont utilisés comme éléments reconfigurables de base. La combinaison de ces éléments permet d'augmenter la taille du filtre à réaliser ou bien de réaliser plusieurs fonctions de filtrage distinctes simultanément.

Ce dispositif DFR permet de traiter notamment des données au format entier, au format virgule fixe ou au format virgule flottante. La taille et le format des données à traiter est fonction du choix d'implémentation. Le dispositif peut donc traiter, par exemple, des données de grande dynamique en provenance d'un capteur vidéo.

Les deux dispositifs de filtrage numérique à structure hiérarchique 51, 52 sont connectés entre eux grâce à un module d'aiguillage 8×8 53. Ce module 53 est reconfigurable et permet de router les flux présentés aux ports d'entrée du dispositif 54, les résultats intermédiaires des dispositifs DFSH et les sorties 55. Les flux d'entrée 54 sont dirigés soit vers les ports d'entrée principaux 56, 58 soit vers les ports d'entrée secondaires 57, 59 de l'un 51 ou l'autre 52 des dispositifs DFSH. Les résultats disponibles sur les ports de sortie principaux 60, 62 ou secondaires 61, 63 sont routés soit en sortie du dispositif DFR 55 soit vers les ports d'entrée principaux ou secondaires de l'autre dispositif DFSH. Cette deuxième option permet d'augmenter la taille de la fonction de filtrage à réaliser.

Le module d'aiguillage 53 est programmable et permet une utilisation flexible des ressources de calcul 51, 52. Il est à noter que plus le module d'aiguillage 53 est flexible, c'est-à-dire qu'il peut être programmé de nombreuses manières différentes, plus son coût en surface de silicium est élevé. Un module d'aiguillage 8×8, également appelé, selon la terminologie anglo-saxonne « switch 8×8 », permet de gérer huit entrées et huit sorties. Ainsi les flux d'entrée, les flux de sortie et les résultats intermédiaires des DFSH sont routés en fonction de l'utilisation voulue du dispositif. Le module d'aiguillage peut être implémenté, notamment, en utilisant un circuit « crossbar » offrant une grande maximale. Il est également possible de synthétiser un switch 8×8 à partie, par exemple, de plusieurs switch 2×2.

L'exemple de dispositif DFR selon l'invention illustré par la figure 3 peut être utilisé notamment dans un système embarqué de traitement d'image nécessitant une forte puissance de calcul. Il a été souligné précédent que le module d'aiguillage 53 permet une utilisation flexible du dispositif. Le dispositif est capable d'exécuter jusqu'à quatre filtres linéaires de taille N simultanément. Mais il peut être également être configuré pour réaliser deux filtres de longueur 2×N ou bien un filtre de longueur 4×N. Ainsi, ce dispositif est efficace notamment dans le cadre de systèmes vidéo stéréoscopiques car deux images indépendantes peuvent être traitées en X et en Y simultanément avec deux filtres alloués à chacune des images.

Un module DFR comporte par exemple 4 entrées et 4 sorties de flux d'échantillons, les flux d'entrée pouvant être routés vers les deux 2 ports d'entrées principaux et les 2 ports d'entrées secondaires des dispositifs DFSH compris dans le dispositif DFR. Le dispositif DFR peut ainsi être configuré en 4 filtres récursifs indépendants traitant simultanément 4 flux indépendants d'échantillons. En effet les modules MF compris dans les dispositifs DFSH comportent des moyens pour réaliser la fonction de filtre récursif à partir d'un flux d'échantillon, c'est-à-dire une somme pondérée avec résultat rebouclé. Comme un module DFSH 51, 52 possède 2 entrées et 2 sorties indépendantes, il est possible de réaliser 2 filtres récursifs indépendants. Ainsi en combinant 2 modules DFSH, un module DFR permet de configurer 4 filtres récursifs indépendants et à exécution simultanée, le débit de traitement pour chaque sortie étant de un échantillon par cycle d'horloge.

Un dispositif de type DFR est reconfigurable mais n'est pas microprogrammé. En d'autres termes, il n'est pas dépendant d'un microcode. Un dispositif externe comme un processeur CPU peut initialement configurer les modules switch 8x8 53, DFSH 51, 52, MF, les aiguillages ainsi que les constantes multiplicatives des modules MF par une interface de configuration simple. Une fois la configuration terminée l'exécution des filtres est autonome et automatique. Le circuit réagit uniquement au flot de données d'entrée. Ce sont les flux d'entrées qui déclenchent le calcul de filtrage et non un CPU externe.

## Revendications

**1.** Dispositif de filtrage à structure hiérarchique configurable pour permettre de réaliser soit des fonctions de filtrage linéaire à réponse impulsionnelle finie soit à réponse impulsionnelle infinie et pouvant être combiné avec un ou plusieurs dispositifs du même type, ledit dispositif comportant au moins un premier (1) et un second (2) module de filtrage comportant des moyens pour réaliser des fonctions de filtrage à N coefficients configurables,
un premier sous ensemble des N coefficients d'un module de filtrage étant configuré de manière à réaliser des fonctions de filtrage non-récursif, un second sous ensemble desdits coefficients pouvant être configuré de manière à réaliser des fonctions de filtrage récursif, une ou plusieurs boucles de contre-réaction pouvant être activée par module de filtrage, le dispositif étant configuré de manière à ce que les échantillons de sortie du premier module de filtrage sont dirigés soit directement en entrée du second module de filtrage soit vers un port de sortie du dispositif de filtrage, au moins un échantillon de résultat du filtrage étant généré à chaque cycle d'horloge, le dispositif de filtrage comportant au moins :

un port d'entrée principal (4) transmettant au dispositif de filtrage un flux d'échantillons à filtrer, ledit port étant connecté aux deux modules de filtrage (1, 2) ;

un port d'entrée secondaire (3) connecté au premier module de filtrage (1) permettant de transmettre un second flux d'échantillons au dispositif de filtrage ;

un port de sortie principal (11) permettant de transmettre le résultat des opérations de filtrage en sortie du dispositif de filtrage après combinaison (10) des flux en sortie de chaque module de filtrage reconfigurable ;

un port de sortie secondaire (12) permettant de transmettre un résultat après filtrage composé d'un flux d'échantillons pris en sortie du second module de filtrage (2), ledit port pouvant être connecté au port d'entrée secondaire (3) d'un autre dispositif de filtrage numérique ; et

un premier circuit LIFO placé en sortie du premier module de filtrage (1) et un deuxième circuit LIFO placé en entrée du second module de filtrage (2) pour générer des flux d'échantillons anti-causaux, lesdits circuits LIFO n'étant pas activés lorsque les modules de filtrage sont configurés pour réaliser des filtres à réponse impulsionnelle finie et lesdits circuits LIFO étant activés lorsque les modules de filtrage sont configurés pour réaliser des filtres à réponse impulsionnelle infinie, lesdits circuits LIFO, lorsqu'ils sont activés, réalisent simultanément un traitement récursif causal du flux d'échantillons à filtrer, l'ordre des échantillons en sortie du premier module de filtrage étant inversé par le premier circuit LIFO et un traitement récursif anti-causal du flux d'échantillons à filtrer dont l'ordre des échantillon est inversé par le deuxième circuit LIFO.

2. Dispositif de filtrage selon la revendication 1 **caractérisé en ce que** le flux d'échantillons présenté au port d'entrée secondaire (3) est un flux d'échantillons à traiter indépendant du flux présenté au port d'entrée principal (4).

3. Dispositif de filtrage selon la revendication 1 **caractérisé en ce que** le flux d'échantillons est un flux en provenance d'un autre dispositif de filtrage à structure hiérarchique, les deux dispositifs étant connectés afin de réaliser une fonction de filtrage d'ordre supérieur à N.

4. Dispositif de filtrage selon l'une quelconque des revendications précédentes **caractérisé en ce que** les valeurs des coefficients de filtrage utilisés par chaque module de filtrage sont stockées dans des registres programmables.

5. Dispositif de filtrage selon l'une quelconque des revendications précédentes **caractérisé en ce qu'**il comporte un module de synchronisation (9) permettant de compenser automatiquement les différences de latence entre les sorties des deux modules de filtrage (1, 2).

6. Dispositif de filtrage selon l'une quelconque des revendications précédentes **caractérisé en ce que** chaque module de filtrage (1, 2) utilisé par le dispositif de filtrage comporte au moins N multiplieurs (43), N cellules à retard (42), deux arbres d'additionneurs (32, 33), un port d'entrée principale (36), un port d'entrée secondaire (37), un port de sortie principale (38) et un port de sortie secondaire (39).

7. Dispositif de filtrage selon la revendication 6 caractérisé en ce chaque module de filtrage (1, 2) utilisé par le dispositif de filtrage comporte une fonction de réalignement (34) en amont du port de sortie principale (38) lorsque les échantillons à traiter sont représentés au format virgule fixe et une fonction de compensation (35) placé en amont du port de sortie secondaire (39) permettant d'équilibrer les latences introduites par les multiplieurs (43) et les arbres d'additionneurs (32, 33).

8. Dispositif de filtrage selon l'une quelconque des revendications précédentes **caractérisé en ce que** le routage des flux de données en interne du dispositif de filtrage est choisi à l'aide à de bascules d'aiguillage (6, 8, 45, 48).

9. Dispositif de filtrage selon l'une quelconque des revendications précédentes caractérisé en qu'il est configurable en un filtre à réponse impulsionnelle infinie 2D d'ordre N/2, ce filtre étant obtenu de la manière suivante :

- les deux modules de filtrage (1, 2) sont configurés en mode récursifs avec leurs boucles de contre réaction activées ;
- les deux circuits LIFO (5, 7) placés respectivement en sortie du premier module de filtrage et en entrée du second module de filtrage sont activés ;
- le port d'entrée principal (4) est utilisé et passe par le premier module de filtrage (1) pour réaliser un traitement récursif causal dont l'ordre des échantillons est inversé par le premier circuit LIFO (5) disposé en sortie du premier module de filtrage ;
- le flux d'échantillons présenté au port d'entrée principal (4) est inversé par le second circuit LIFO (7) et passe par le second module de filtrage (2) pour la réalisation d'un traitement anti-causal ;

- les traitements causaux et anti-causaux sont synchronisés par un module de synchronisation (9) et combinés par un additionneur/soustracteur (10), puis les échantillons résultats sont dirigés vers le port de sortie principal (11) ;
- une deuxième passe de calcul est effectuée sur les échantillons résultats issus des modules de filtrage avec des coefficients appropriés afin de réaliser la fonction de filtrage à réponse impulsionnelle infinie 2D d'ordre m.

**10.** Dispositif de filtrage selon l'une quelconque des revendications précédentes caractérisé en qu'il est configurable en deux filtres à réponse impulsionnelle finie 2D d'ordre N ces filtres étant obtenus de la manière suivante :

- les deux modules de filtrage (1, 2) sont configurés en mode non-récursifs sans boucle de contre-réaction activée ;
- un flux d'échantillons est présenté au niveau du port d'entrée secondaire (3) et passe par le premier module de filtrage (1), ledit module réalisant le traitement correspondant au premier filtre à réponse impulsionnelle finie ;
- le module de synchronisation (9) est configuré pour ne laisser passer que le flux issu du premier module de filtrage (1) par une de ses sorties, la seconde sortie étant à forcée à 0.
- l'additionneur (10) transmet le flux inchangé d'échantillons de sortie du premier module de filtrage (1) vers le port de sortie principal (11) ;
- un flux d'échantillons d'entrée présenté au niveau du port d'entrée principal (4) et indépendant du flux présenté au niveau du port d'entrée secondaire (3) est transmis au second module de filtrage (2) pour réaliser le deuxième filtre à réponse impulsionnelle finie 2D ;
- une deuxième passe sur les résultats précédents dans ces modules avec des coefficients appropriés réalise la fonction à réponse impulsionnelle finie 2D d'ordre N.

**11.** Dispositif de filtrage selon l'une quelconque des revendications précédentes caractérisé en qu'il est configurable en un filtre à réponse impulsionnelle finie 2D d'ordre 2xN, ce filtre étant obtenu de la manière suivante :

- les deux modules de filtrage (1, 2) sont configurés en mode non-récursifs sans boucle de contre réaction activée ;
- le premier module de filtrage (1) est configuré pour réaliser un traitement sur les échantillons présentés sur son port d'entrée secondaire, et le second module de filtrage (2) est configuré pour réaliser un traitement sur les échantillons présentés sur son port d'entrée principal ;
- les deux circuits LIFO (5, 7) ne sont pas activés ;
- les deux multiplexeurs (6, 8) sont configurés de manière à contourner les circuits LIFO ;
- un flux d'échantillons est présenté au niveau du port d'entrée secondaire (3) et passe par le premier module de filtrage (1), ledit module réalisant le traitement correspondant au premier filtre à réponse impulsionnelle finie ;
- le module de synchronisation (9) est configuré pour ne laisser passer que le flux issu du premier module MF (1) par une de ses sorties, la seconde sortie étant à forcée à 0 ;
- l'additionneur (10) transmet le flux inchangé d'échantillons de sortie du premier module de filtrage 1 vers le port de sortie principal (11) ;
- un flux d'échantillons d'entrée présenté au niveau du port d'entrée principal (4) et indépendant du flux présenté au niveau du port d'entrée secondaire (3) est transmis au second module de filtrage (2) pour réaliser le deuxième filtre à réponse impulsionnelle finie 2D ;
- une deuxième passe sur les résultats précédents dans ces modules avec des coefficients appropriés réalise la fonction à réponse impulsionnelle finie 2D d'ordre N.

**12.** Dispositif de filtrage reconfigurable utilisant au moins deux dispositifs de filtrage à structure hiérarchique (51, 52) tels que définis selon l'une quelconque des revendications précédentes, ledit dispositif étant **caractérisé en ce qu'**il comporte au moins :

- quatre ports d'entrée (54) permettant de présenter en entrée du dispositif de filtrage un ou plusieurs flux d'échantillons à filtrer ;
- quatre ports de sortie (55) permettant de présenter en sortie du dispositif de filtrage le ou les flux résultant de la ou des opérations de filtrage réalisées par le dispositif de filtrage ;
- un circuit d'aiguillage reconfigurable (53) permettant d'une part de router les flux d'entrée (54) soit vers les ports d'entrée principaux (56, 58) soit vers les ports d'entrée secondaires (57, 59) de l'un (51) ou l'autre (52) des dispositifs de filtrage reconfigurable, et d'autre part de router les résultats disponibles sur les ports de sortie principaux (60, 62) ou secondaires (61, 63) des dispositifs de filtrage reconfigurable soit en sortie du dispositif de filtrage reconfigurable (55) soit vers les ports d'entrée principaux au secondaires d'un autre dispositif de filtrage à structure hiérarchique.


**Patentansprüche**

**1.** Filtervorrichtung mit hierarchischer Struktur, welche konfigurierbar ist, um die Ausführung entweder von linearen Filterfunktionen mit endlicher Impulsantwort, oder mit unendlicher Impulsantwort zu ermöglichen und welche mit einer oder mehreren Vorrichtungen gleicher Art kombiniert werden kann, wobei die Vorrichtung mindestens ein erstes (1) und ein zweites (2) Filtermodul beinhaltet, welche Mittel beinhalten, um Filterfunktionen mit N konfigurierbaren Koeffizienten auszuführen,
wobei eine erste Untermenge der N Koeffizienten eines Filtermoduls konfiguriert ist, um nicht rekursive Filterfunktionen auszuführen, wobei eine zweite Untermenge der Koeffizienten konfiguriert werden kann, um rekursive Filterfunktionen auszuführen, wobei eine oder mehrere Gegenkopplungsschleifen pro Filtermodul aktiviert werden können, wobei die Vorrichtung so konfiguriert ist, dass die Ausgangs-Abtastwerte des ersten Filtermoduls entweder direkt an den Eingang des zweiten Filtermoduls, oder an einen Ausgangsanschluss der Filtervorrichtung geleitet werden, wobei mindestens ein Ergebnis-Abtastwert der Filterung bei jedem Uhr-Zyklus erzeugt wird, wobei die Filtervorrichtung mindestens Folgendes beinhaltet:

einen Haupteingangsanschluss (4), welcher einen Strom von zu filternden Abtastwerten an die Filtervorrichtung überträgt, wobei der Anschluss an die beiden Filtermodule (1, 2) angeschlossen ist;
einen sekundären Eingangsanschluss (3), welcher an das erste Filtermodul (1) angeschlossen ist und es ermöglicht, einen zweiten Strom von Abtastwerten an die Filtervorrichtung zu übertragen;
einen Hauptausgangsanschluss (11), welcher es ermöglicht, das Ergebnis der Filterschritte am Ausgang der Filtervorrichtung nach Kombination (10) der Ströme am Ausgang eines jeden umkonfgurierbaren Filtermoduls zu übertragen;
einen sekundären Ausgangsanschluss (12), welcher es ermöglicht, ein Ergebnis nach der Filterung, bestehend aus einem Abtastwertstrom, der am Ausgang des zweiten Filtermoduls (2) abgenommen wird, zu übertragen, wobei der Anschluss an den sekundären Eingangsanschluss (3) einer anderen digitalen Filtervorrichtung angeschlossen werden kann; und
einen ersten LIFO-Schaltkreis, welcher am Ausgang des ersten Filtermoduls (1) platziert ist und einen zweiten LIFO-Schaltkreis, welcher am Eingang des zweiten Filtermoduls (2) platziert ist, um antikausale Abtastwertströme zu erzeugen, wobei die LIFO-Schaltkreise nicht aktiviert werden, wenn die Filtermodule konfiguriert sind, um Filter mit endlicher Impulsantwort zu bilden, und die LIFO-Schaltkreise aktiviert werden, wenn die Filtermodule konfiguriert sind, um Filter mit unendlicher Impulsantwort zu bilden, wobei die LIFO-Schaltkreise, wenn sie aktiviert sind, gleichzeitig eine rekursive, kausale Verarbeitung des zu filternden Abtastwertstroms durchführen, wobei die Reihenfolge der Abtastwerte am Ausgang des ersten Filtermoduls durch den ersten LIFO-Schaltkreis umgekehrt wird, und eine rekursive, antikausale Verarbeitung des zu filternden Abtastwertstroms durchführen, wobei die Reihenfolge der Abtastwerte durch den zweiten LIFO-Schaltkreis umgekehrt wird.

**2.** Filtervorrichtung nach Anspruch 1, **dadurch gekennzeichnet, dass** der Abtastwertstrom, welcher am sekundären Eingangsanschluss (3) anliegt, ein zu verarbeitender Abtastwertstrom ist, welcher unabhängig von demjenigen Strom ist, der am Haupteingangsanschluss (4) anliegt.

**3.** Filtervorrichtung nach Anspruch 1, **dadurch gekennzeichnet, dass** der Abtastwertstrom ein von einer anderen Filtervorrichtung mit hierarchischer Struktur stammender Strom ist, wobei die beiden Vorrichtungen verbunden sind, um eine Filterfunktion höherer Ordnung als N durchzuführen.

**4.** Filtervorrichtung nach einem der vorhergehenden Ansprüche, **dadurch gekennzeichnet, dass** die Werte der durch jedes Filtermodul eingesetzten Filterkoeffizienten in den programmierbaren Registern gespeichert werden.

**5.** Filtervorrichtung nach einem der vorhergehenden Ansprüche, **dadurch gekennzeichnet, dass** sie ein Synchronisierungsmodul (9) beinhaltet, welches es ermöglicht, automatisch die Latenzdifferenzen zwischen den Ausgängen der beiden Filtermodule (1, 2) zu kompensieren.

**6.** Filtervorrichtung nach einem der vorhergehenden Ansprüche, **dadurch gekennzeichnet, dass** jedes Filtermodul (1, 2), welches durch die Filtervorrichtung verwendet wird, mindestens N Multiplizierer (43), N Verzögerungszellen (42), zwei Summiererbäume (32, 33), einen Haupteingangsanschluss (36), einen sekundären Eingangsanschluss (37), einen Hauptausgangsanschluss (38) und einen sekundären Ausgangsanschluss (39) beinhaltet.

**7.** Filtervorrichtung nach Anspruch 6, **dadurch gekennzeichnet, dass** jedes Filtermodul (1, 2), welches durch die Filtervorrichtung verwendet wird, eine ReAlignment-Funktion (34) im vorgelagerten Bereich des Hauptausgangsanschlusses (38) beinhaltet, wenn die zu verarbeitenden Abtastwerte im Festkommaformat dargestellt werden und eine Kompensationsfunktion (35), welche im vorgelagerten Bereich des sekundären Ausgangsanschlusses (39) platziert ist, welche es ermöglicht, die durch die Multiplizierer (43) und die Summiererbäume (32, 33) induzierten Latenzen auszugleichen.

**8.** Filtervorrichtung nach einem der vorhergehenden Ansprüche, **dadurch gekennzeichnet, dass** das Routing der Datenströme intern in der Filtervorrichtung mit Hilfe von Flipflop-Weichen (6, 8, 45, 48) gewählt wird.

**9.** Filtervorrichtung nach einem der vorhergehenden Ansprüche, **dadurch gekennzeichnet, dass** sie zu einem 2D-Filter mit unendlicher Impulsantwort der Ordnung N/2 konfigurierbar ist, wobei dieser Filter wie folgt erzielt wird:

- die beiden Filtermodule (1, 2) sind im rekursiven Modus konfiguriert, wobei ihre Gegenkopplungsschleifen aktiviert sind;
- die beiden LIFO-Schaltkreise (5, 7), welche jeweils am Ausgang des ersten Filtermoduls und am Eingang des zweiten Filtermoduls platziert sind, sind aktiviert;
- der Haupteingangsanschluss (4) wird verwendet und passiert das erste Filtermodul (1), um eine rekursive, kausale Verarbeitung vorzunehmen, wobei die Reihenfolge der Abtastwerte durch den ersten LIFO-Schaltkreis (5) umgekehrt wird, welcher am Ausgang des ersten Filtermoduls angeordnet ist;
- der Abtastwertstrom, der am Haupteingangsanschluss (4) anliegt, wird durch den zweiten LIFO-Schaltkreis (7) umgekehrt und passiert das zweite Filtermodul (2) zur Durchführung einer antikausalen Verarbeitung;
- die kausalen und antikausalen Verarbeitungen werden durch ein Synchronisierungsmodul (9) synchronisiert und durch einen Summierer/Subtrahierer (10) kombiniert, und die Ergebnis-Abtastwerte werden anschließend an den Hauptausgangsanschluss (11) geleitet;
- ein zweiter Berechnungsdurchgang erfolgt an den Ergebnis-Abtastwerten, welche den Filtermodulen entstammen, mit geeigneten Koeffizienten, um die 2D-Filterfunktion mit unendlicher Impulsantwort der Ordnung m auszuführen.

**10.** Filtervorrichtung nach einem der vorhergehenden Ansprüche, **dadurch gekennzeichnet, dass** sie zu zwei 2D-Filtern mit endlicher Impulsantwort der Ordnung N konfigurierbar ist, wobei diese Filter wie folgt erzielt werden:

- die beiden Filtermodule (1, 2) sind im nicht rekursiven Modus ohne aktivierte Gegenkopplungsschleife konfiguriert;
- ein Abtastwertstrom liegt am sekundären Eingangsanschluss (3) an und passiert das erste Filtermodul (1), wobei das Modul die dem ersten Filter mit endlicher Impulsantwort entsprechende Verarbeitung durchführt;
- das Synchronisierungsmodul (9) ist konfiguriert, um nur den aus dem ersten Filtermodul (1) stammenden Strom durch einen von seinen Ausgängen passieren zu lassen, wobei der zweite Ausgang zwangsweise auf 0 gesetzt wird;
- der Summierer (10) überträgt den unveränderten Ausgangs-Abtastwertstrom des ersten Filtermoduls (1) an den Hauptausgangsanschluss (11);
- ein Eingangs-Abtastwertstrom, der am Haupteingangsanschluss (4) anliegt und von dem am sekundären Eingangsanschluss (3) anliegenden Strom unabhängig ist, wird an das zweite Filtermodul (2) übertragen, um den zweiten 2D-Filter mit endlicher Impulsantwort zu bilden;
- ein zweiter Durchgang an den vorhergehenden Ergebnissen in diesen Modulen mit geeigneten Koeffizienten führt die 2D-Funktion mit endlicher Impulsantwort der Ordnung N durch.

**11.** Filtervorrichtung nach einem der vorhergehenden Ansprüche, **dadurch gekennzeichnet, dass** sie zu einem 2D-Filter mit endlicher Impulsantwort der Ordnung 2xN konfigurierbar ist, wobei dieser Filter wie folgt erzielt wird:

- die beiden Filtermodule (1, 2) sind im nicht rekursiven Modus ohne aktivierte Gegenkopplungsschleife konfiguriert;
- das erste Filtermodul (1) ist konfiguriert, um eine Verarbeitung an den an seinem sekundären Eingangsanschluss anliegenden Abtastwerten auszuführen, und das zweite Filtermodul (2) ist konfiguriert, um eine Verarbeitung an den an seinem Haupteingangsanschluss anliegenden Abtastwerten auszuführen;
- die beiden LIFO-Schaltkreise (5, 7) sind nicht aktiviert;
- die beiden Multiplexer (6, 8) sind so konfiguriert, dass sie die LIFO-Schaltkreise umgehen;
- ein Abtastwertstrom liegt am sekundären Eingangsanschluss (3) an und passiert das erste Filtermodul (1), wobei das Modul die dem ersten Filter mit endlicher Impulsantwort entsprechende Verarbeitung durchführt;
- das Synchronisierungsmodul (9) ist konfiguriert, um nur den aus dem ersten Modul MF (1) stammenden Strom durch einen von seinen Ausgängen passieren zu lassen, wobei der zweite Ausgang zwangsweise auf 0 gesetzt wird;
- der Summierer (10) überträgt den unveränderten Ausgangs-Abtastwertstrom des ersten Filtermoduls 1 an den Hauptausgangsanschluss (11);
- ein Eingangs-Abtastwertstrom, der am Haupteingangsanschluss (4) anliegt und von dem am sekundären Eingangsanschluss (3) anliegenden Strom unabhängig ist, wird an das zweite Filtermodul (2) übertragen, um den zweiten 2D-Filter mit endlicher Impulsantwort zu bilden;
- ein zweiter Durchgang an den vorhergehenden Ergebnissen in diesen Modulen mit geeigneten Koeffizienten führt die 2D-Funktion mit endlicher Impulsantwort der Ordnung N durch.

12. Umkonfigurierbare Filtervorrichtung, welche mindestens zwei Filtervorrichtungen mit hierarchischer Struktur (51, 52) nach einem der vorhergehenden Ansprüche verwendet, wobei die Vorrichtung **dadurch gekennzeichnet ist, dass** sie mindestens Folgendes beinhaltet:

- vier Eingangsanschlüsse (54), welche es ermöglichen, am Eingang der Filtervorrichtung einen oder mehrere zu filternde Abtastwertströme anzulegen;
- vier Ausgangsanschlüsse (55), welche es ermöglichen, am Ausgang der Filtervorrichtung den Strom oder die Ströme anzulegen, welche aus dem oder den Filterschritten resultieren, welche durch die Filtervorrichtung vorgenommen werden;
- einen umkonfigurierbaren Weichenschaltkreis (53), welcher es einerseits ermöglicht, die Eingangsströme (54) entweder an die Haupteingangsanschlüsse (56, 58) oder an die sekundären Eingangsanschlüsse (57, 59) der einen (51) oder der anderen (52) der umkonfigurierbaren Filtervorrichtungen zu routen, und andererseits, die an den Hauptausgangsanschlüssen (60, 62) oder an den sekundären Ausgangsanschlüssen (61, 63) der umkonfigurierbaren Filtervorrichtungen verfügbaren Ergebnisse entweder an den Ausgang der umkonfigurierbaren Filtervorrichtung (55) oder an die Haupteingangsanschlüsse oder die sekundären Eingangsanschlüsse einer anderen Filtervorrichtung mit hierarchischer Struktur zu routen.

## Claims

1. A filtering device having a hierarchical structure configurable to carry out either finite impulse response linear filtering functions or infinite impulse response linear filtering functions and being able to be combined with one or more devices of the same type, said device comprising at least one first (1) and second (2) filtering module, comprising means for carrying out filtering functions with N configurable coefficients,
wherein a first subset of the N coefficients of a filtering module is configured to carry out non-recursive filtering functions, a second subset of said coefficients can be configured to carry out recursive filtering functions, one or more feedback loops can be activated per filtering module, the device being configured such that the output samples of the first filtering module are either directed directly at the input of the second filtering module or at an output port of the filtering device, at least one result sample of the filtering result being generated at each clock cycle, the filtering device comprising at least:

a main input port (4) transmitting, to the filtering device, a stream of samples to be filtered, said port being connected to the two filtering modules (1, 2);
a secondary input port (3) connected to the first filtering module (1) to transmit a second stream of samples to the filtering device;
a main output port (11) to transmit the result of the filtering operations at the output of the filtering device after combination (10) of the streams at the output of each reconfigurable filtering module;
a secondary output port (12) to transmit a result after filtering consisting of a stream of samples taken at the output of the second filtering module (2), said port being able to be connected to the secondary input port (3) of another digital filtering device; and
a first LIFO circuit placed at the output of the first filtering module (1) and a second LIFO circuit placed at the input of the second filtering module (2) to generate anti-causal streams of samples, said LIFO circuits being inactivated when the filtering modules are configured to execute finite impulse response filters and the LIFO circuits being activated when the filtering modules are configured to execute infinite impulse response filters, said LIFO circuits, when activated, simultaneously carrying out a causal recursive processing of the stream of samples to be filtered, the order of samples at the output of the first filtering module being reversed by the first LIFO circuit and an anti-causal recursive processing of the stream of samples to be filtered, where the order of the samples is reversed by the second LIFO circuit.

2. The filtering device according to claim 1, **characterized in that** the stream of samples presented to the secondary input port (3) is a stream of samples to be processed and is independent of the stream presented to the main input port (4).

3. The filtering device according to claim 1, **characterized in that** the stream of samples is a stream originating from another filtering device having a hierarchical structure, the two devices being connected to execute a filtering function of order greater than N.

4. The filtering device according to any one of the preceding claims, **characterized in that** the values of the filtering coefficients used by each filtering module are stored in programmable registers.

5. The filtering device according to any one of the preceding claims, **characterized in that** it comprises a synchronization module (9) allowing to automatically compensate for differences in latency between the outputs of the two filtering modules (1, 2).

6. The filtering device according to any one of the preceding claims, **characterized in that** each filtering module (1, 2) used by the filtering device comprises at least N multipliers (43), N delay cells (42), two trees of adders (32, 33), a main input port (36), a secondary input port (37), a main output port (38), and a secondary output port (39).

7. The filtering device according to claim 6, **characterized in that** each filtering module (1, 2) used by the filtering device comprises a realignment function (34) upstream of the main output port (38) when the samples to be filtered are represented in fixed point format and a compensation function (35) placed upstream of the secondary output port (39) to balance latencies introduced by the multipliers (43) and the trees of adders (32, 33).

8. The filtering device according to any one of the preceding claims, **characterized in that** the routing of the data streams internally in the filtering device is chosen using steering flip-flops (6, 8, 45, 48).

9. The filtering device according to any one of the preceding claims, **characterized in that** it is configurable as an infinite impulse response filter 2D of order N/2, said filter being obtained in the following way:

- the two filtering modules (1, 2) are configured in recursive modes with their feedback loops activated;
- the two LIFO circuits (5, 7) that are placed respectively at the output of the first filtering module and at the input of the second filtering module are activated;
- the main input port (4) is used and passes through the first filtering module (1) to carry out a causal recursive processing, wherein the order of samples is reversed by the first LIFO circuit (5) disposed at the output of the first filtering module;
- the stream of samples presented to the main input port (4) is reversed by the second LIFO circuit (7) and passes through the second filtering module (2) to execute an anti-causal processing;
- the causal processing and the anti-causal processing are synchronized by a synchronization module (9) and combined by an adder/subtracter (10), then resulting samples are directed toward the main output port (11);
- a second computational pass is performed on the resulting samples arising from the filtering modules using appropriate coefficients in order to execute the infinite impulse response function 2D of order m.

10. The filtering device according to any one of the preceding claims, **characterized in that** it is configurable as two finite impulse response filters 2D of order N, said filters being obtained in the following way:

- the two filtering modules (1, 2) are configured in non-recursive mode without a feedback loop being activated;
- a stream of samples is presented to the secondary input port (3) and passes through the first filtering module (1), said module executing processing corresponding to the first finite impulse response filter;
- the synchronization module (9) is configured to let through only the stream arising from the first filtering module (1) via one of its outputs, the second output being forced to 0;
- the adder (10) transmits the unchanged stream of output samples from the first filtering module (1) to the main output port (11);
- a stream of input samples that is presented to the main input port (4) and is independent of the stream presented to the secondary input port (3) is transmitted to the second filtering module (2) to produce the second finite impulse response filter 2D;

- a second pass on the previous results in said modules using appropriate coefficients executes the finite impulse response function 2D of order N.

11. The filtering device according to any one of the preceding claims, **characterized in that** it is configurable as a finite impulse response filter 2D of order 2xN, said filter being obtained in the following way:

- the two filtering modules (1, 2) are configured in non-recursive mode without the feedback loop being activated;
- the first filtering module (1) is configured to execute a processing on the samples presented to its secondary input port, and the second filtering module (2) is configured to execute processing on the samples presented to its main input port;
- the two LIFO circuits (5, 7) are not activated;
- the two multiplexers (6, 8) are configured to bypass the LIFO circuits;
- a stream of samples is presented at the secondary input port (3) and passes through the first filtering module (1), said module executing the processing corresponding to the first finite impulse response filter;
- the synchronization module (9) is configured to let through only the stream arising from the first module MF (1) via one of its outputs, the second output being forced to 0;
- the adder (10) transmits the unchanged stream of output samples from the first filtering module 1 to the main output port (11);
- a stream of input samples that is presented at the main input port (4) and is independent of the stream presented at the secondary input port (3) is transmitted to the second filtering module (2) to produce the second finite impulse response filter (2D);
- a second pass on the preceding results in these modules using appropriate coefficients executes the finite impulse response function 2D of order N.

12. A reconfigurable filtering device using at least two filtering devices having a hierarchical structure (51, 52) as defined in any one of the preceding claims, said device being **characterized in that** it comprises at least:

- four input ports (54) to present, as an input to the filtering device, one or more streams of samples to be filtered;
- four output ports (55) to present, as an output from the filtering device, the one or more streams resulting from a filtering operation or filtering operations executed by the filtering device;
- a reconfigurable steering circuit (53), on the one hand to route the input streams (54) either toward the main input ports (56, 58) or toward the secondary input ports (57, 59) of one (51) or the other (52) of the reconfigurable filtering devices, and on the other hand to route the results available on the main output ports (60, 62) or the secondary output ports (61, 63) of the reconfigurable filtering devices either as output from the reconfigurable filtering device (55) or toward the main input ports or the secondary input ports of another filtering device having a hierarchical structure.

FIG.1

FIG.3

FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0623996 A